# EUROPÄISCHE PATENTANMELDUNG

(11) **EP 0 649 026 A2**
(43) Veröffentlichungstag der Anmeldung: **19.04.1995**
(21) Anmeldenummer: 94114481.8
(22) Anmeldetag: 15.09.1994
(51) Int. Cl.: G01R 15/08, G01R 15/09, G01R 15/12

(54) **Multimeter mit automatischer Messfunktionseinstellung**

(30) Priorität: 18.09.1993 DE 4331796
(71) Anmelder: GOSSEN-METRAWATT Gesellschaft mit beschränkter Haftung, D-90471 Nürnberg (DE)
(72) Erfinder: Schulze, Wolfgang, D-90419 Nürnberg (DE); Krien, Burkhard, D-91154 Roth (DE); Meier, Bernd, Dr., D-92353 Postbauer-Heng (DE); Feulner, Dieter, D-90530 Wendelstein (DE)
(74) Vertreter: Hafner, Dieter, Dr.rer.nat., Dipl.-Phys.

(57) **Zusammenfassung**

Bei einem Multimeter mit automatischer Meßfunktionseinstellung und automatischer Meßbereichserkennung erfolgt das Erkennen der zu messenden elektrischen Größe bei hochohmigem Eingangswiderstand. Bei als Impedanzen erkannten Meßgrößen wird automatisch auf einen niederohmigen Eingangswiderstand umgeschaltet, die Meßgröße wird niederohmig gemessen und nachfolgend angezeigt, und bei einer Meßbereichsänderung wird wieder zum Anfang der Meßprozedur zurückgekehrt.

## Beschreibung

Die vorliegende Erfindung betrifft digitale Multimeter, insbesondere Handmultimeter, die eine Vielzahl von Meßfunktionen, wie die Messung von Spannung, Widerstand, Kapazität und Strom ausführen können und über eine automatische Meßbereichseinstellung sowie über eine automatische Meßfunktionseinstellung verfügen.

Nach dem Stand der Technik ist aus EP 0 435 431 ein Multimeter mit automatischer Meßfunktionseinstellung für Spannungs-/Widerstands- bzw. Spannungs-/Diodenmessung bekannt. Hierbei ist ein mit dem Eingang des Multimeters verbundener Erkennungsschaltkreis vorgesehen, der das analoge Signal erfaßt und die Charakteristik desselben in Form logischer Signale weitergibt, um einen nachgeschalteten Umwandlerschaltkreis zu veranlassen, die entsprechende Umwandelfunktion auszuführen und dann den gemessenen umgewandelten Wert als Funktion des analogen Eingangssignals anzuzeigen.

Eine Weiterbildung von Multimetern mit automatischer Meßfunktionseinstellung ist in EP 0 487 174 beschrieben. Insbesondere ist hier ein Controller vorgesehen, der sowohl einen AD-Wandler als auch den Signalerkennungsschaltkreis steuert. Die hier vorgeschlagene Vorrichtung ist im Vergleich zur obenbeschriebenen schneller und einfacher und kostengünstiger herstellbar.

Die nach dem Stand der Technik bekannten Multimeter mit automatischer Meßfunktionseinstellung beziehen sich auf einen relativ niederohmigen Eingang des Multimeters, über den sowohl Impedanzen als auch Spannungen meßbar sind. Die niederohmige Messung von Spannung kann in vielen Fällen jedoch hinderlich sein, da die zu messende Spannungsquelle belastet wird und dies zu Meßfehlern führen kann. Zur Minimierung derartiger Meßfehler sind Digitalmultimeter üblicherweise mit einem Eingangswiderstand im Bereich von 10 Megaohm ausgestattet. Bei diesen Multimetern wird die Meßfunktion jedoch bislang manuell über einen Funktionsschalter eingestellt.

Aufgabe der Erfindung ist es, eine Schaltungsvorrichtung für digitale Multimeter mit automatischer Meßfunktionseinstellung anzugeben, die einfach und kostengünstig herstellbar ist und über einen weiten Meßbereich eine exakte Messung elektrischer Kenngrößen ermöglicht.

Diese Aufgabe wird durch die kennzeichnenden Merkmale der unabhängigen Ansprüche gelöst, wobei sich zweckmäßige Weiterbildungen der Erfindung aus den in den Unteransprüchen wiedergegebenen Merkmalen ergeben.

Nach Maßgabe der Erfindung wird ein Verfahren zum automatischen Erkennen und zur Messung elektrischer Meßgrößen bei einem Multimeter mit automatischer Meßbereichswahl vorgeschlagen, wobei die Meßgröße durch einen am Eingang vorgesehenen Erkennungsschaltkreis detektiert wird, derart, daß das Erkennen der zu messenden elektrischen Größe bei hochohmigem Eingangswiderstand erfolgt, daß bei als Impedanzen erkannten Meßgrößen automatisch auf einen niederohmigen Eingangswiderstand umgeschaltet wird, daß die Meßgröße niederohmig gemessen und nachfolgend angezeigt wird, und daß bei einer Meßbereichsänderung wieder zum Anfang der Meßprozedur zurückgekehrt wird. Zweckmäßigerweise werden bei dem vorgeschlagenen Verfahren Widerstände und Kondensatoren als Impedanzen gemessen.
Das vorgeschlagene Verfahren kann selbstverständlich Bestandteil eines komplexeren Meßverfahrens sein, welches vorteilhafterweise prozeßrechnergesteuert abläuft.

Gemäß einer weiteren Lösung ist vorrichtungsseitig zum automatischen Erkennen und Messen elektrischer Meßgrößen, insbesondere mittels eines Multimeters eine Schalteinrichtung zum automatischen Umschalten von einem hochohmigen auf einen niederohmigen Eingangswiderstand in Abhängigkeit der erkannten Meßgröße vorgesehen, wobei es sich bei der Meßgröße vorteilhafterweise um eine Impedanz handelt.

Die Schalteinrichtung umfaßt zweckmäßigerweise ein bistabiles Relais sowie wenigstens zwei CMOS-Schalter. Wie bereits bei der obigen Verfahrensbeschreibung angedeutet, kann die Schalteinrichtung vorteilhafterweise prozeßrechnergesteuert sein.

Gerade im Hinblick auf eine kostengünstige Herstellung der vorgeschlagenen Schaltung ist eine Zusammenfassung wesentlicher Bestandteile der Schalteinrichtung in einem CMOS-Baustein vorgesehen.

Gemäß einer weiteren Lösung umfaßt ein Multimeter mit automatischer Meßfunktionseinstellung sowie mit automatischer Meßbereichswahl die obenbeschriebene erfindungsgemäße Vorrichtung. Das Multimeter kann hierbei im wesentlichen nach dem Stand der Technik gestaltet sein und über eine manuelle Funktionswahl neben der erfindungsgemäßen automatischen Funktionswahl verfügen.

Ferner ist zum Bau eines erfindungsgemäßen Multimeters die Verwendung herkömmlicher Multimeter-Bausteine vorgesehen.

Eine vorteilhafte Ausgestaltungsform der vorliegenden Erfindung wird nunmehr anhand der beiliegenden Zeichnungen näher erläutert. Hierin zeigen:
- Fig. 1: eine schematische Darstellung der Meßprozedur,
- Fig. 2: ein Prinzipschaltbild einer erfindungsgemäßen Vorrichtung,
- Fig. 3: das Prinzipschaltbild nach Fig. 2 im Falle der Stromerkennung,
- Fig. 4: das Prinzipschaltbild nach Fig. 2 im Falle der Spannungserkennung,
- Fig. 5: das Prinzipschaltbild nach Fig. 2 im Falle der Widerstandserkennung bzw. bei Erkennung großer Kapazität,
- Fig. 6: das Prinzipschaltbild nach Fig. 2 im Falle der Erkennung großer Kapazität,
- Fig. 7: das Prinzipschaltbild nach Fig. 2 im Falle der Erkennung kleiner Kapazität,
- Fig. 8: das Prinzipschaltbild nach Fig. 2 im Falle der Gleichspannungsmessung,
- Fig. 9: das Prinzipschaltbild nach Fig. 2 im Falle der Wechselspannungsmessung,
- Fig. 10: das Prinzipschaltbild nach Fig. 2 im Falle der Widerstandsmessung, und
- Fig. 11: das Prinzipschaltbild nach Fig. 2 im Falle der Kapazitätsmessung.

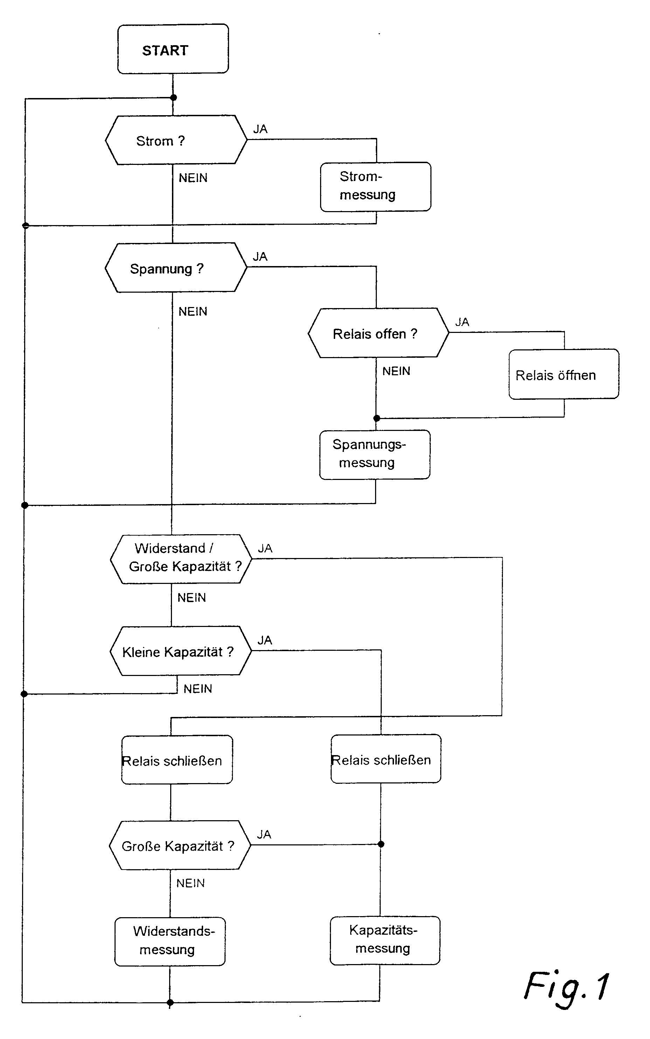

Fig. 1 beschreibt beispielsweise den Ablauf der Funktionsauswahl bzw. die Meßprozedur in Form eines Flußdiagramms. In jedem Schritt wird nach bestimmten Kriterien untersucht, ob eine bestimmte Meßgröße anliegt. Falls ja, dann wird die Meßgröße über bekannte Methoden der automatischen Meßbereichswahl möglichst präzise gemessen und angezeigt. Die einmal gewählte Meßfunktion bleibt beibehalten, bis sich der Meßbereich ändert. Anschließend beginnt die Klassifizierung der Meßgröße von neuem.

Gemäß des hier vorliegenden Ausführungsbeispiels wird zu Beginn geprüft, ob ein Strom anliegt, wenn ja, wird der Strom gemessen und angezeigt, bis sich der Meßbereich ändert. Anschließend beginnt die Meßprozedur erneut. Sofern kein Strom über eine Strommeßklemme fließt, wird geprüft, ob eine Spannung an den Eingangsklemmen anliegt. Wenn ja, wird die Stellung eines Relais überprüft und dieses gegebenenfalls in die hochohmige Spannungsmeßposition geschaltet. Anschließend folgt die Spannungsmessung solange, bis keine Spannung mehr anliegt. Danach beginnt die Funktionswahl von neuem, d.h. die Meßprozedur kehrt an ihren Ausgangspunkt zurück.

Wenn keine Spannung anliegt, wird geprüft, ob ein Widerstand oder eine große Kapazität anliegt. Falls ja, wird das Relais geschlossen, d.h. es wird auf einen niederohmigen Eingangswiderstand umgeschaltet. Bei geschlossenem Relais wird geprüft, ob eine große Kapazität anliegt. Wenn ja, wird die Kapazität gemessen. Wenn nein, wird der Widerstand gemessen. Die Messungen werden solange wiederholt, bis sich der Meßbereich ändert. Im Falle einer Änderung des Meßbereichs beginnt-die Funktionswahl erneut.

Wenn kein Widerstand und keine große Kapazität anliegt, wird geprüft, ob eine kleine Kapazität anliegt. Wenn ja, wird das Relais geschlossen, die Kapazität gemessen und angezeigt. Die Messung wird wiederholt, bis sich der Meßbereich ändert. Anschließend beginnt die Funktionswahl erneut.

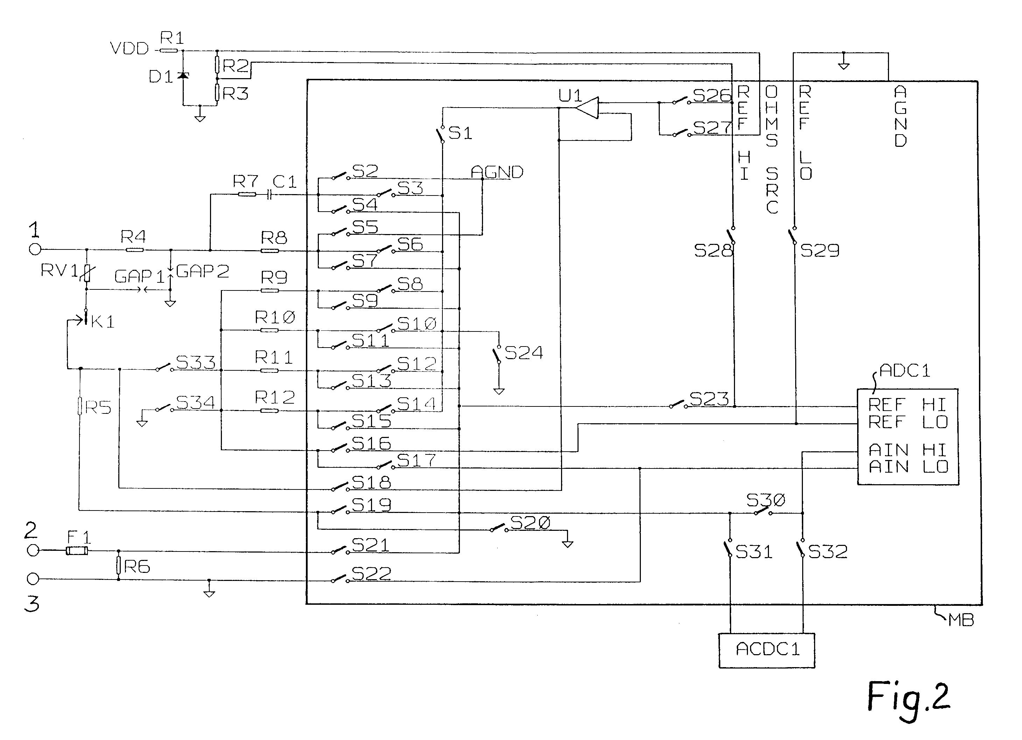

Fig. 2 zeigt beispielhaft ein Prinzipschaltbild der erfindungsgemäßen Vorrichtung. Das Multimeter hat drei Eingangsklemmen, Eingangsklemme 1 für Spannungs-, Widerstands- und Kapazitätsmessung, Eingangsklemme 2 für Strommessungen und Eingangsklemme 3 als Bezug.

Ein Widerstand R4 dient zusammen mit einer Funkenstrecke GAP2 als Schutz im Spannungspfad gegen energiereiche Spannungsspitzen. Ein PTC-Widerstand RV1 sichert zusammen mit einer Funkenstrecke GAP1 einen Impedanzmeßpfad ab. Eine Sicherung F1 bietet Schutz im Strommeßpfad.

Eine Referenzspannung für einen AD-Wandler ADC1 wird über eine Zehnerdiode D1 und den Spannungsteiler R2, R3 erzeugt und über die Schalter S28, S29 an dessen Referenzspannungseingänge geführt. Bei dem hier verwendeten AD-Wandler ADC1 handelt es sich um einen AD-Wandler mit vorgeschaltetem Filter nach dem Stand der Technik.

Ein Spannungsmeßpfad führt über R4, R8, S6 für Gleichspannung bzw. R4, R7, C1, S3 für Wechselspannung und dann über einen der mit dem entsprechenden Schalter zugeschalteten Teilerwiderstände R9 bis R12 und S34 gegen einen Bezugspunkt. Aufgrund der Tatsache, daß die elektronischen Schalter einen nicht zu vernachlässigenden Übergangswiderstand aufweisen, sind Spannungsabgriffe an den Teilerwiderständen sowie an dem Bezugspunkt vorgesehen. Ein Meßsignal gelangt über einen Spannungsabgriff bei Gleichspannung über einen Schalter S30 bzw. bei Wechselspannung über einen Schalter S31, einen Gleichrichter ACDC1 und einen Schalter S32 auf den AD-Wandler ADC1. Der Bezugspunktabgriff erfolgt über einen Schalter S17. Der hier verwendete Gleichrichter ACDC1 entspricht einem marktgängigen Typ, z.B. AD636 mit vorgeschaltetem Chopperbuffer.

Ein Impedanzmeßpfad führt über den Kaltleiter RV1, ein Relais K1 und einen Schalter S33 auf die Referenzwiderstände R9 bis R12, von denen einer je nach Bereich zugeschaltet wird. Über Schalter S23 und S16 kann der Spannungsabfall am Referenzwiderstand als Referenzspannung für den AD-Wandler ADC1 abgegriffen werden. Der Spannungsabfall des zu messenden Widerstands wird über Schalter S19 und S22 abgegriffen.

Ein Strommeßpfad führt über die Sicherung F1 und einen Shunt R6. Die Spannungsabgriffe werden über Schalter S21 und S22 bzw. über den Gleichspannungs- bzw. Wechselspannungspfad wie bei der Spannungsmessung dem AD-Wandler ADC1 zugeführt.

Hier nicht dargestellt ist ein Mikroprozessor, der den AD-Wandler und die Schalter steuert. Ebenfalls nicht dargestellt sind gewisse Eingangsschutzschaltungen für das Multimeter IC sowie Stütz- und Glättungskondensatoren, eine Stromversorgung, eine Bedientastatur sowie ein Display.

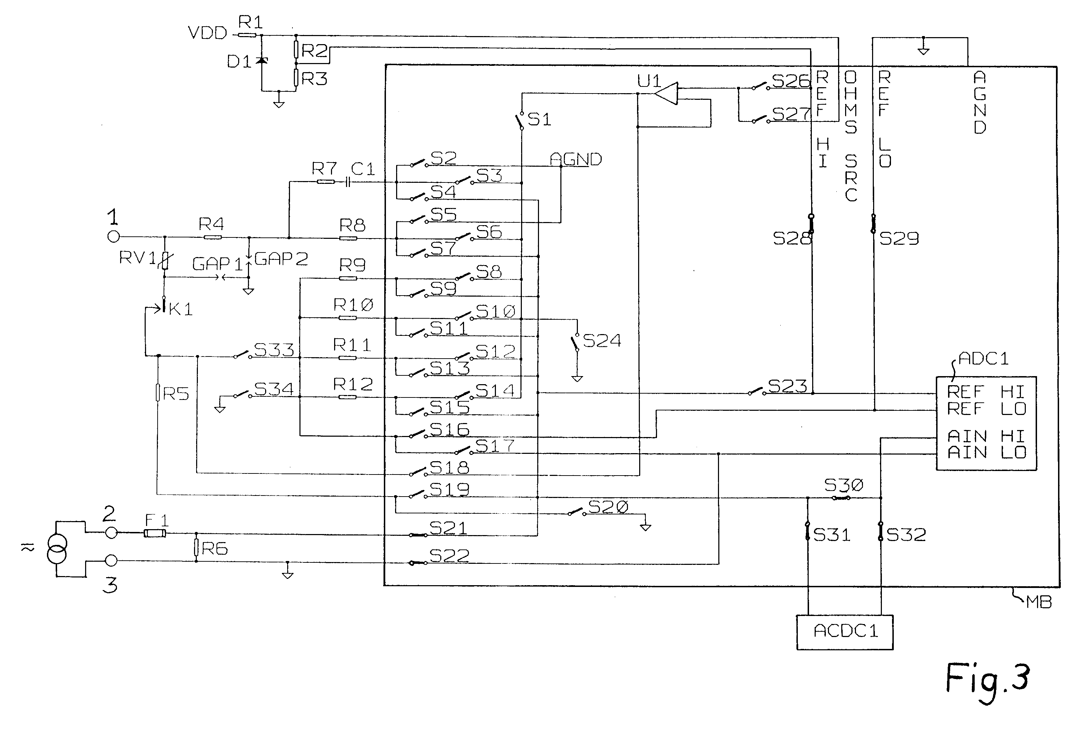

Fig. 3 zeigt das Prinzipschaltbild nach Fig. 2 im Falle der Stromerkennung. Hierbei ist das Relais K1 entweder offen oder geschlossen. Der zu messende Gleichstrom wird über den Shunt R6 in eine Spannung gewandelt. Diese Spannung gelangt über die Schalter S21 und S30 bzw. der Wechselspannungsanteil über die Schalter S21 und S31, den Gleichrichter ACDC1, den Schalter 32 auf den positiven Eingang des AD-Wandels ADC1. Der negative Eingang desselben ist über den Schalter S22 an den Bezugspunkt gekoppelt. Die Referenz des AD-Wandlers ADC1 wird über den Schalter S28 an einen positiven Referenzsignaleingang REF HI und über den Schalter S29 an einen negativen Referenzspannungseingang REF LO, den Bezugspunkt angekoppelt. Der Mikroprozessor steuert die Schalter so, daß zunächst eine Gleichstrom- und dann eine Wechselstrommessung durchgeführt wird.

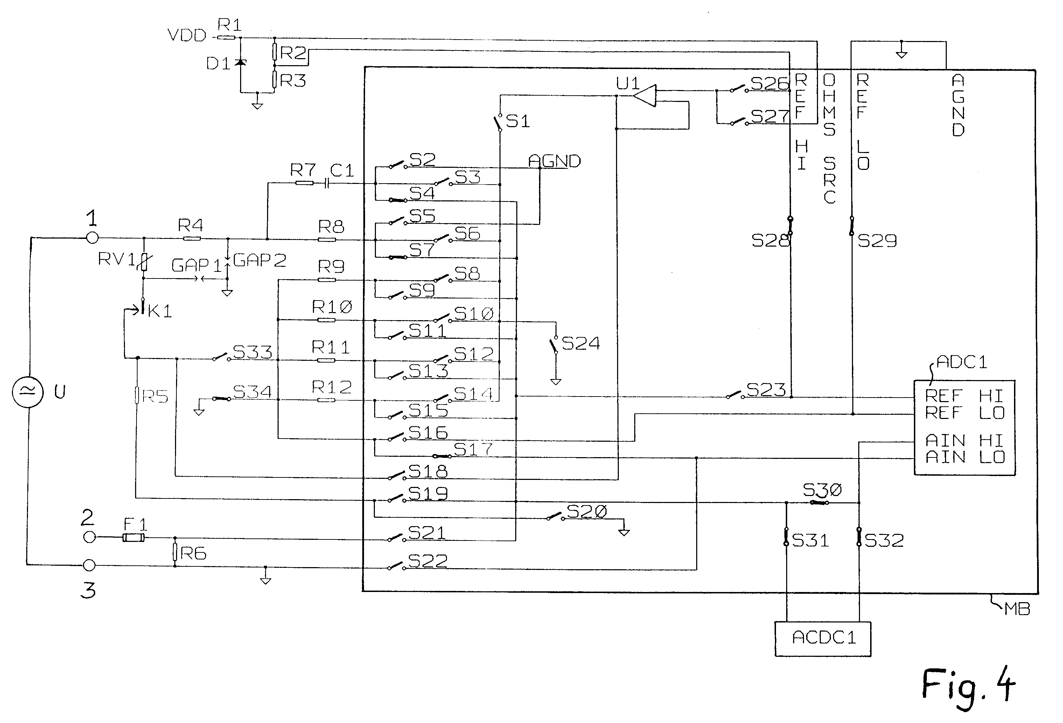

Fig. 4 zeigt das Prinzipschaltbild nach Fig. 2 im Falle der Spannungserkennung. Das Relais K1 ist offen oder geschlossen. Die zu messende Gleichspannung gelangt über die Widerstände R4 und R8 sowie über Schalter S7 und S30 bzw. der Wechselspannungsanteil über die Widerstände R4 und R7, einen Kondensator C1 sowie Schalter S4 und S31, den Gleichrichter ACDC1, den Schalter S32 auf den positiven Eingang des AD-Wandlers. Der negative Eingang des AD-Wandlers ist über die Schalter S17 und S34 an den Bezugspunkt angekoppelt. Die Referenz des AD-Wandlers wird über S28 am positiven Referenzspannungseingang REF HI und über den Schalter S29 am negativen Referenzspannungseingang REF LO, dem Bezugspunkt angekoppelt. Der Mikroprozessor steuert die Schalter so, daß zunächst eine Gleichspannungs- und dann eine Wechselspannungsmessung durchgeführt wird.

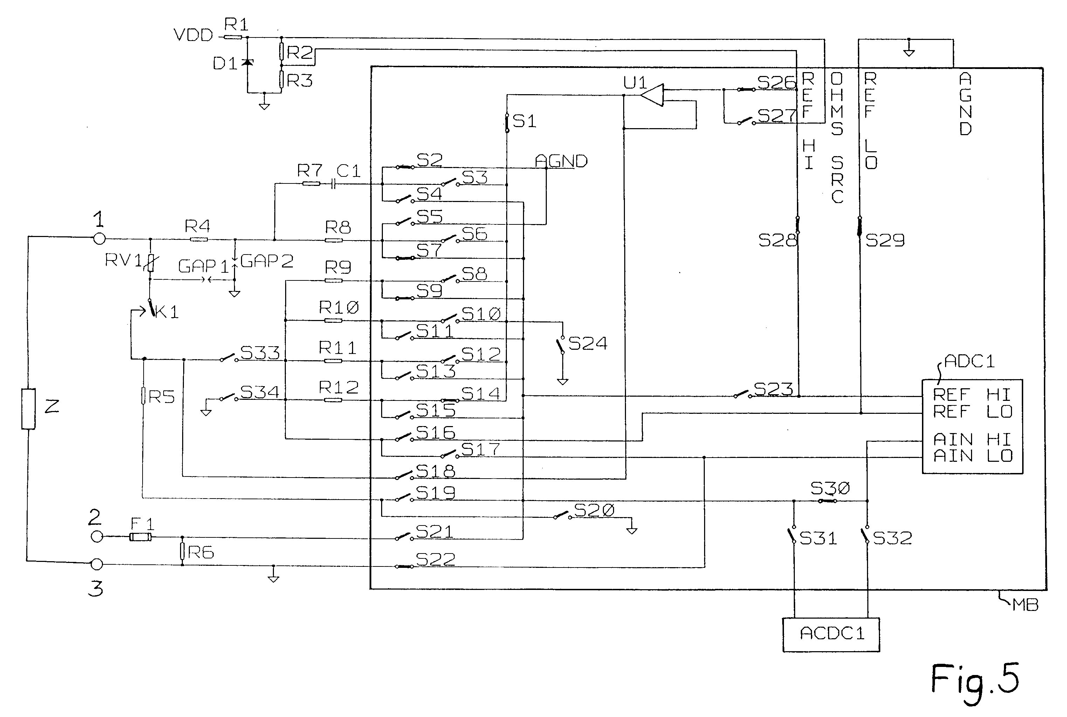

Fig. 5 zeigt das Prinzipschaltbild nach Fig. 2 im Falle der Widerstandserkennung bzw. zur Erkennung großer Kapazitäten. Die Referenzspannung REF HI wird über einen Schalter S26, einen Spannungsfolger U1, und im weiteren über S1, S14, R12, R9, S9, S7, R8 und R4 an die Eingangsklemme 1 gelegt. Die Spannung hinter dem Widerstand R9 wird nach einer vorgegebenen Zeit über S9, S30 auf AIN HI und S22 auf AIN LO des A/D -Wandlers ADC1 gemessen. Wenn keine Impedanz oder ein kleiner zum Zeitpunkt der Messung bereits aufgeladener Kondensator anliegt, ist die Spannung gleich der Referenzspannung. Ist die Spannung kleiner als die Referenzspannung, liegt ein Widerstand oder ein großer Kondensator an.

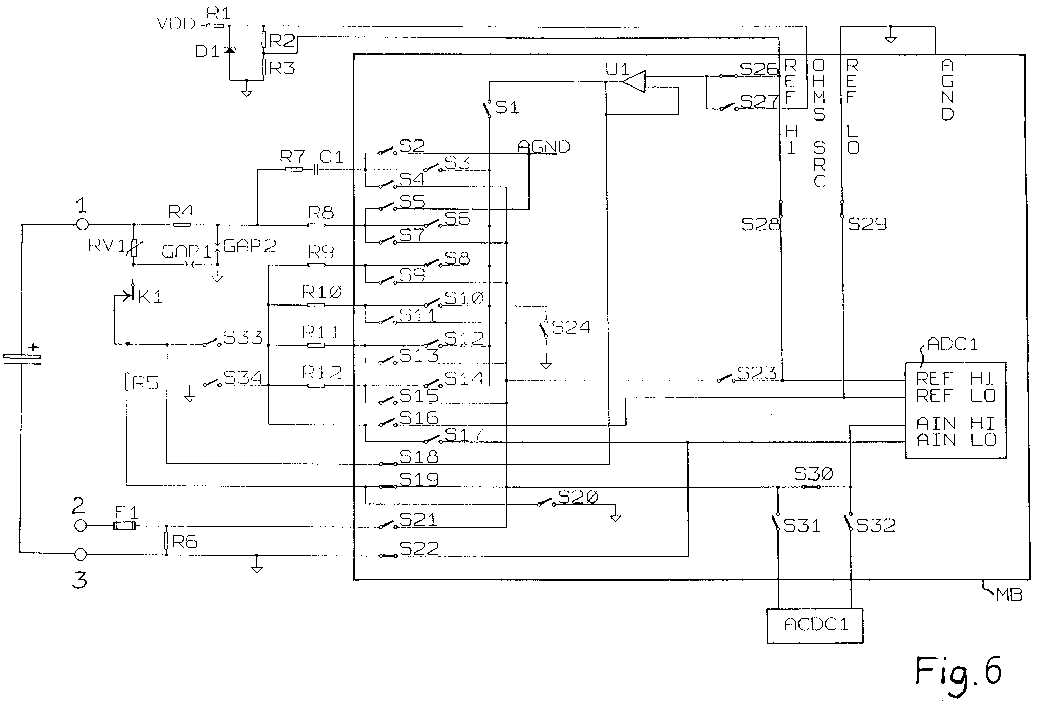

Fig. 6 zeigt das Prinzipschaltbild nach Fig. 2 im Falle der Erkennung großer Kapazitäten. Das Relais K1 ist geschlossen. Die Referenzspannung REF HI wird über den Schalter S26, den Spannungsfolger U1, einen Schalter S18 und das Relais K1 an die Eingangsklemme 1 gelegt. Nach einer Zeitspanne wird der Schalter S18 geöffnet. Zweimal mit einer kurzen Zwischenzeitspanne wird die Spannung am Kondensator über den Kaltleiter RV1 und im weiteren über K1, R5, S19, S30 auf AIN HI und über den Schalter S22 auf AIN LO gemessen. Wenn eine Kapazität anliegt, gleichen sich die Spannungswerte annähernd. Die Kapazität wird nun mit einer Kapazitätsmessung ermittelt.

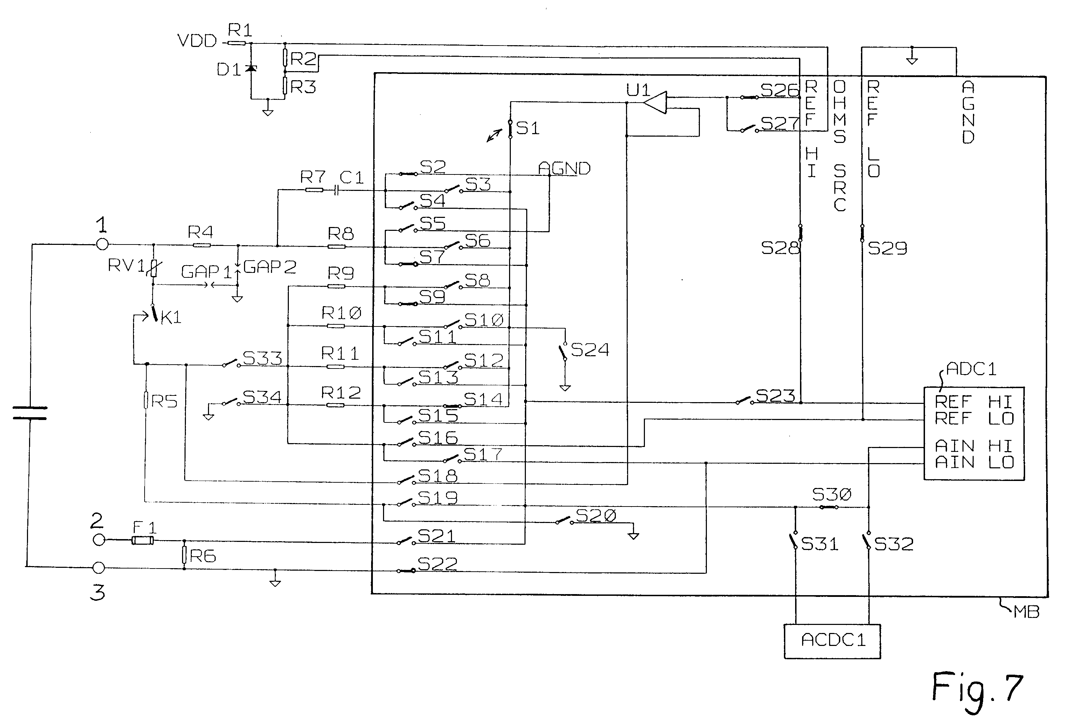

Fig. 7 zeigt das Prinzipschaltbild nach Fig. 2 im Falle der Erkennung kleiner Kapazitäten. Die Referenzspannung REF HI wird über den Schalter S26, den Spannungsfolger U1 sowie über S1, S14, R12, R9, S9, S7, R8 und R4 an die Eingangsklemme 1 gelegt. Die Spannung hinter dem Widerstand R9 wird über S9, S30, auf AIN HI und über S22 auf AIN LO gemessen. Wenn keine Impedanz oder ein kleiner zum Zeitpunkt der Messung bereits aufgeladener Kondensator anliegt, ist die Spannung gleich der Referenzspannung. Die treibende Spannung wird über den Schalter S1 abgeschaltet und es wird wiederholt gemessen. Wenn ein Kondensator anliegt, gleichen sich die beiden Meßwerte annähernd. Anschließend wird das Relais K1 geschlossen und eine Kapazitätsmessung durchgeführt.

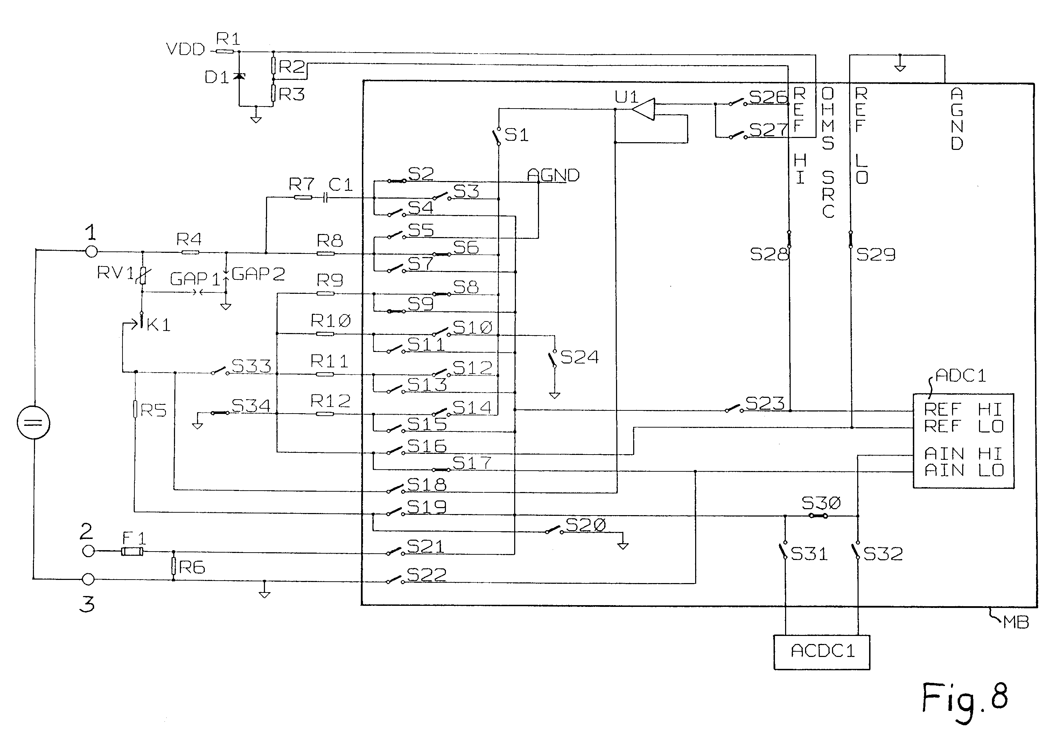

Fig. 8 zeigt das Prinzipschaltbild nach Fig. 2 im Falle der Gleichspannungsmessung. Das Relais K1 ist offen oder geschlossen. Das Signal gelangt über die Widerstände R4, R8 sowie den Schalter S6 auf den Mittelabgriff des Spannungsteilers. Im Beispiel ist der Teilerwiderstand R9 über S8 und S34 zugeschaltet. Die Spannung am Teiler wird über den Schalter S9 abgegriffen und über den Schalter S30 dem AD-Wandler ADC1 zugeführt. AIN LO ist über die Schalter S34 und S17 verbunden. Die Referenzspannung gelangt über S28 und S29 an den AD-Wandler.

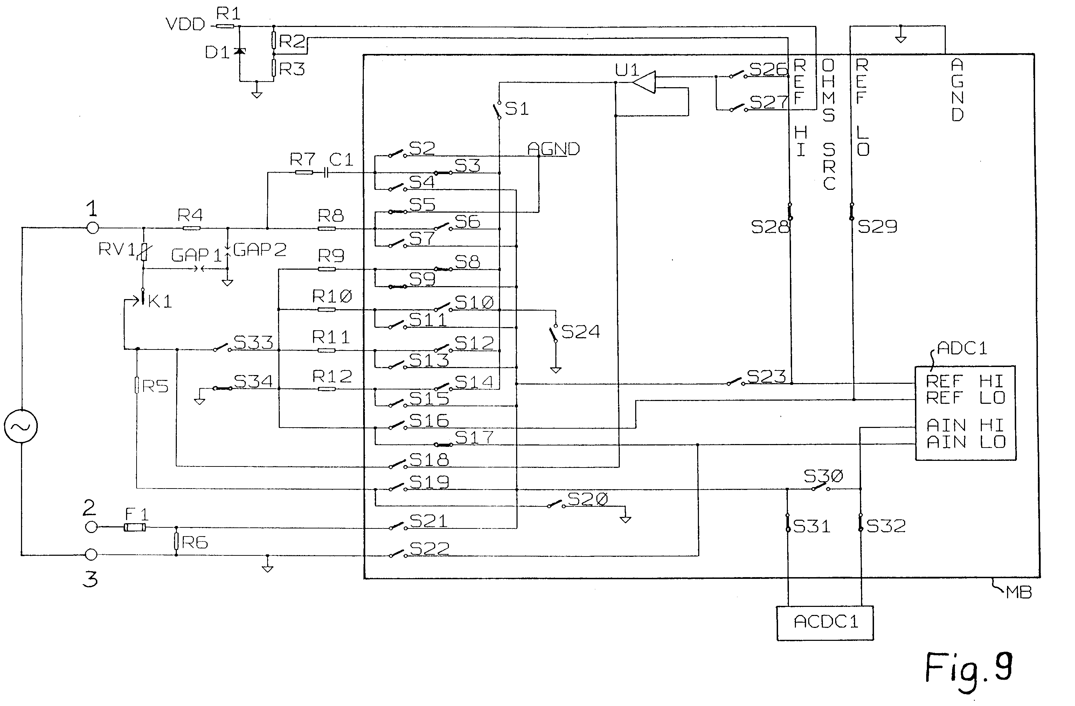

Fig. 9 zeigt das Prinzipschaltbild nach Fig. 2 im Falle der Wechselspannungsmessung. Das Relais K1 ist offen oder geschlossen. Das Signal gelangt über die Widerstände R4, R7 sowie den Kondensator C1 und den Schalter S2 auf den Mittelabgriff des Spannungsteilers. Im Beispiel ist der Teilerwiderstand R9 über die Schalter S8 und S34 zugeschaltet. Die Spannung am Teiler wird über S9 abgegriffen, und über den Schalter S31, den Gleichrichter ACDC1 und den Schalter S32 dem AD-Wandler zugeführt. IN LO ist über die Schalter S34 und S17 verbunden. Referenzspannung gelangt über die Schalter S28 und S29 an den AD-Wandler.

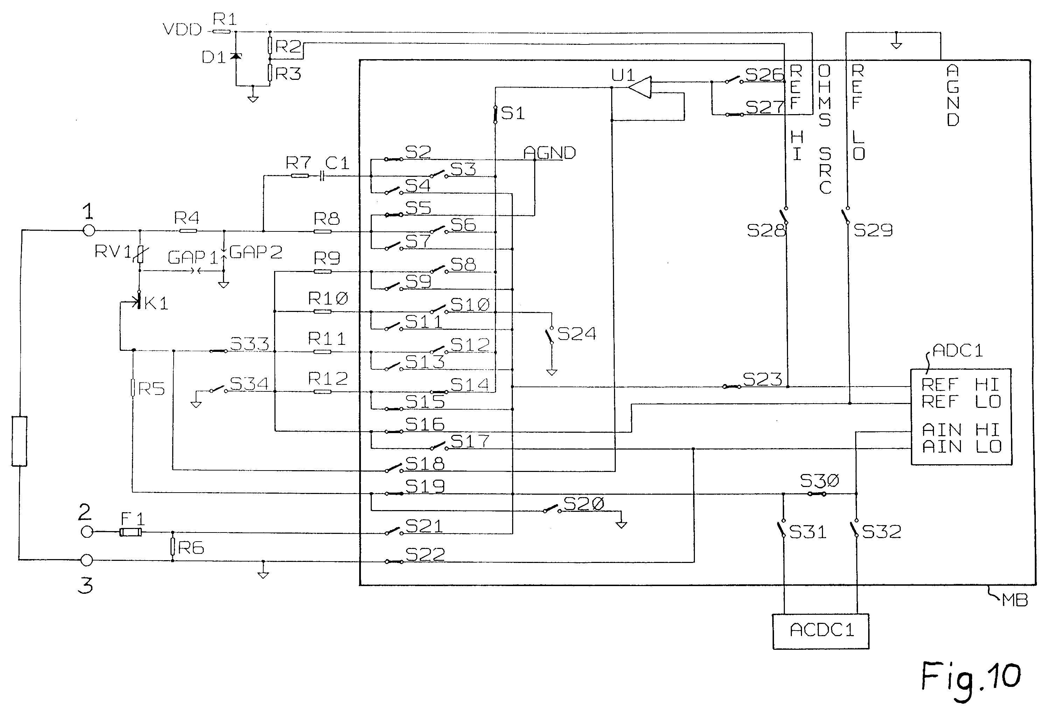

Fig. 10 zeigt das Prinzipschaltbild nach Fig. 2 im Falle der Widerstandsmessung. Das bekannte Ratio-Verfahren wird hier angewandt. Das Relais K1 ist geschlossen. Die Widerstandsspannung OHMS SRC gelangt über einen Schalter S27, den Spannungsfolger U1 und den Schalter S1 auf eine Referenzwiderstandsschiene. Im Beispiel wird der Widerstand R12 über den Schalter S14 eingeschaltet. Der Strom fließt weiter über S33, K1, RV1 und die Klemme über den zu messenden Widerstand auf das Bezugspotential. Die am Referenzwiderstand anliegende Spannung wird über den Schalter S15 und einen Schalter S16 abgegriffen und über einen Schalter S23 auf REF HI bzw. direkt auf REF LO des AD-Wandlers geführt. Die am Widerstand abfallende Spannung wird über K1, R5, S19, S30 für AIN HI bzw. über den Schalter S22 für AIN LO abgezapft. Der AD-Wandler führt eine Messung durch, deren Ergebnis direkt proportional zum Verhältnis zwischen dem Referenzwiderstand und dem zu messenden Widerstand ist.

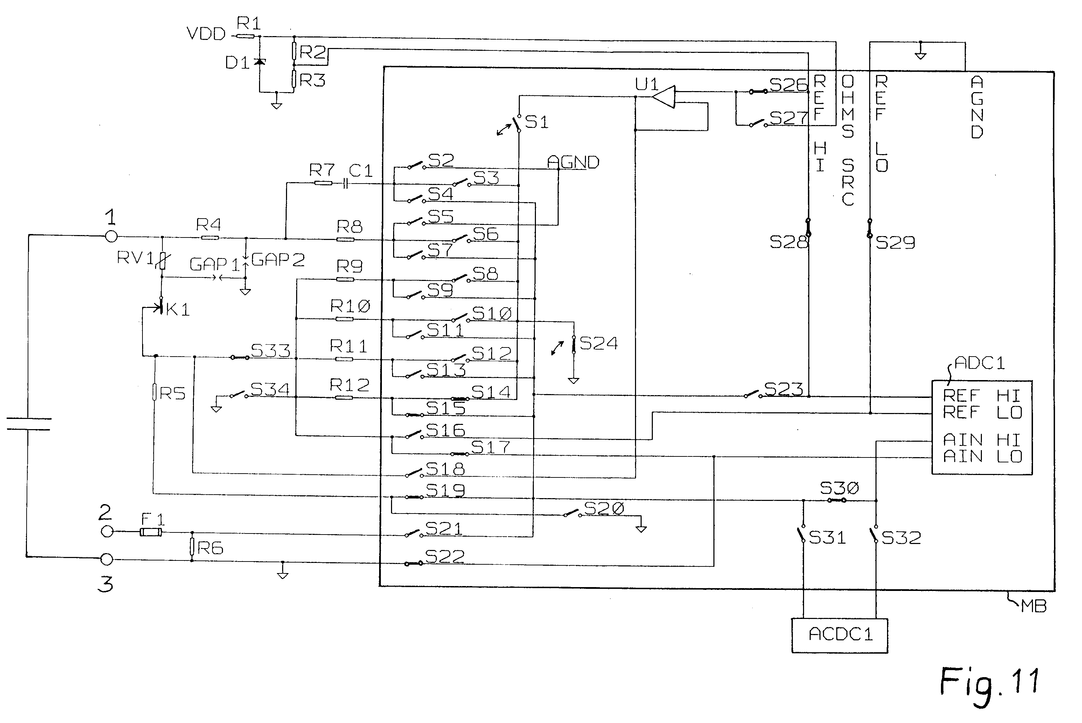

Fig. 11 zeigt das Prinzipschaltbild nach Fig. 2 im Falle der Kapazitätsmessung. Das Relais K1 ist geschlossen. Im ersten Schritt wird der externe Kondensator über RV1, K1, S33, R12, S14 und S24 entladen. Als nächstes wird dieser über REF HI, S26, den Spannungsfolger U1, S1, S14, R12, S33, K1, RV1 geladen. Gleichzeitig wird der dem Strom proportionale Spannungsabfall über R12 über den AIN HI Pfad S15, S30 und den AIN LO Pfad S17 auf dem AD-Wandler ADC1 integriert. Anschließend wird die aufladende Spannung über S1 abgeschaltet und die Spannung am Kondensator über RV1, K1, R5, S19, S30 an AIN HI und S22 an AIN LO gemessen. Die Kapazität ist direkt proportional zu dem Verhältnis aus integriertem Strom und gemessener Spannung.

### BEZUGSZEICHENLISTE

- 1 - 3: Eingangsklemmen
- S1 - S34: Schaltelemente
- R1 - R12: Widerstände
- RV1: Kaltleiter
- GAP1: erste Funkenstrecke
- GAP2: zweite Funkenstrecke
- F1: Sicherung
- D1: Zenerdiode
- ADC1: AD-Wandler mit vorgeschaltetem Filter
- REF HI: Referenzspannungseingang (+)
- REF LO: Referenzspannungseingang (-)
- ACDC1: Gleichrichter
- U1: Spannungsfolger
- MB: Multimeterbaustein

## Patentansprüche

1. Verfahren zum automatischen Erkennen und Messen elektrischer Meßgrößen, insbesondere bei einem Multimeter mit automatischer Meßbereichswahl, wobei die Meßgröße durch einen am Eingang vorgesehenen Erkennungsschaltkreis detektiert wird,
**dadurch gekennzeichnet,**
daß
- das Erkennen der zu messenden elektrischen Größe bei einem hochohmigen Eingangswiderstand (R4, R7, R8) erfolgt,
- bei als Impedanzen erkannten Meßgrößen automatisch auf einen niederohmigen Eingangswiderstand umgeschaltet wird,
- die Meßgröße niederohmig gemessen und angezeigt wird, und
- bei einer Meßbereichsänderung wieder zum Anfang der Meßprozedur zurückgekehrt wird.

2. Verfahren nach Anspruch 1,
**dadurch gekennzeichnet,**
daß auf niederohmigen Eingangswiderstand erst dann umgeschaltet wird, wenn die an den Eingangsklemmen (1, 2, 3) anliegende Spannung gleich Null ist.

3. Verfahren nach Anspruch 1 oder 2,
**dadurch gekennzeichnet,**
daß auf hochohmigen Eingangswiderstand (R4, R7, R8) erst dann zurückgeschaltet wird, wenn an den Eingangsklemmen (1, 2, 3) eine Spannung anliegt.

4. Verfahren nach einem der vorhergehenden Ansprüche,
**dadurch gekennzeichnet,**
daß Widerstände und Kondensatoren als Impedanzen gemessen werden.

5. Verfahren nach einem der vorhergehenden Ansprüche, wobei die Meßprozedur folgende Schritte umfaßt:
- hochohmiges Prüfen, ob Strom fließt,
falls ja: Strommessung und Anzeige des Meßwerts, wobei bei einer Meßbereichsänderung zum Anfang der Meßprozedur zurückgekehrt wird;
- hochohmiges Prüfen, ob Spannung anliegt,
falls ja: Überprüfung der Stellung einer Schalteinrichtung (K1) zum Umschalten von hochohmigen auf niederohmigen Eingangswiderstand (R4, R7, R8) und gegebenenfalls Umschalten auf hochohmigen Eingangswiderstand,
Spannungsmessung und Anzeige, wobei bei einer Meßbereichsänderung zum Anfang der Meßprozedur zurückgekehrt wird;
- hochohmiges Prüfen, ob ein Widerstand oder eine große Kapazität anliegt,
falls ja: Umschalten mittels der Schalteinrichtung auf niederohmigen Eingangswiderstand, Prüfen, ob große Kapazität vorliegt,
falls ja: Kapazitätsmessung und Anzeige, wobei bei einer Meßbereichsänderung zum Anfang der Meßprozedur zurückgekehrt wird;
falls nein: Widerstandsmessung und Anzeige, wobei bei einer Meßbereichsänderung zum Anfang der Meßprozedur zurückgekehrt wird;
- hochohmiges Prüfen, ob eine kleine Kapazität anliegt,
falls ja: Umschalten mittels der Schalteinrichtung auf niederohmigen Eingangswiderstand, Kapazitätsmessung und Anzeige, wobei bei einer Meßbereichsänderung zum Anfang der Meßprozedur zurückgekehrt wird; und
- Rückkehr zum Anfang der Meßprozedur.

6. Vorrichtung zum automatischen Erkennen und Messen elektrischer Meßgrößen, insbesondere mittels eines Multimeters mit automatischer Meßbereichswahl und automatischer Meßfunktionseinstellung,
**dadurch gekennzeichnet**,
daß eine Schalteinrichtung (K1) zum automatischen Umschalten von einem hochohmigen auf einen niederohmigen Eingangswiderstand in Abhängigkeit der erkannten Meßgröße vorgesehen ist.

7. Vorrichtung nach Anspruch 6,
**dadurch gekennzeichnet,**
daß die Meßgröße eine Impedanz ist.

8. Vorrichtung nach Anspruch 6 oder 7,
**dadurch gekennzeichnet,**
daß die Schalteinrichtung (K1) ein prozeßrechnergesteuertes bistabiles Relais und zwei CMOS-Schalter umfaßt.

9. Vorrichtung nach Anspruch 8,
**dadurch gekennzeichnet,**
daß die Schalteinrichtung (K1) im wesentlichen in einem CMOS-Baustein zusammengefaßt ist.

10. Multimeter zum automatischen Erkennen und Messen elektrischer Meßgrößen,
**dadurch gekennzeichnet,**
daß das Multimeter eine Vorrichtung nach Anspruch 6 umfaßt.

11. Multimeter nach Anspruch 10,
**dadurch gekennzeichnet,**
daß das Multimeter eine automatische und eine manuelle Funktionswahl umfaßt.

12. Multimeter nach Anspruch 10 oder 11,
**dadurch gekennzeichnet,**
daß das Multimeter eine automatische Funktionswahl umfaßt, wobei keine Bedienelemente vorgesehen sind.

13. Multimeter nach einem der Ansprüche 10 bis 12,
**dadurch gekennzeichnet,**
daß das Multimeter ein Digitalmultimeter ist.

14. Verwendung eines Multimeter-Bausteins zum Aufbau eines Multimeters nach Anspruch 10.
